# FASCICULE DE BREVET EUROPEEN

(11) **EP 3 167 497 B1**
(45) Date de publication et mention de la délivrance du brevet: **26.08.2020**
(21) Numéro de dépôt: 15736458.9
(22) Date de dépôt: 08.07.2015
(51) Int. Cl.: H01L 51/52

(54) **ENCAPSULATION D'UN COMPOSANT OPTOÉLECTRONIQUE ORGANIQUE**
VERKAPSELUNG EINER ORGANISCHEN OPTOELEKTRONISCHEN KOMPONENTE
ENCAPSULATION OF AN ORGANIC OPTOELECTRONIC COMPONENT

(30) Priorité: 09.07.2014 FR 1456626
(43) Date de publication de la demande: 17.05.2017
(73) Titulaire: Commissariat à l'Énergie Atomique et aux Énergies Alternatives, 75015 Paris (FR); Microoled, 38000 Grenoble (FR)
(72) Inventeur: BONNET, Robin, F-38000 Grenoble (FR); GILET, Jean-Marc, F-38600 Fontaine (FR); MAINDRON, Tony, F-38000 Grenoble (FR); SIMON, Jean-Yves, F-38600 Fontaine (FR)
(74) Mandataire: Priori, Enrico
(86) Numéro de dépôt international: PCT/EP2015/065616
(87) Numéro de publication internationale: WO 2016/005456

(56) Documents cités:
- EP-A2- 2 055 734
- FR-A1- 2 958 795
- FR-A1- 2 973 941
- US-A1- 2007 273 280

## Description

L'invention porte sur l'encapsulation d'un composant optoélectronique organique présentant au moins une surface, dite sensible, devant être protégée de l'oxygène et/ou de l'humidité (vapeur d'eau). Plus particulièrement l'invention porte sur un dispositif encapsulé comprenant un tel composant et une structure multicouche d'encapsulation recouvrant au moins ladite surface sensible, ainsi que sur un procédé d'encapsulation d'un tel composant.

De manière connue, de nombreux composants électriques et optoélectroniques - en particulier mais pas exclusivement ceux à base de matériaux organiques - nécessitent d'être encapsulés, pour assurer la protection de leurs composants sensibles contre l'oxygène et la vapeur d'eau. C'est le cas, par exemple, des diodes électroluminescentes organiques (« OLED ») et des cellules photovoltaïques organiques (« OPV »). Si cette protection n'est pas correctement assurée, il se produit une dégradation des dispositifs, pouvant conduire à leur défaillance. Par exemple, dans le cas des écrans OLED l'on assiste à l'apparition de points noirs non émissifs provoqués par la dégradation de l'interface entre l'anode et/ou la cathode et les couches minces organiques induite par la vapeur d'eau.

La méthode d'encapsulation la plus simple pour les dispositifs sensibles à l'eau et l'oxygène consiste à coller par-dessus lesdits dispositifs un capot en verre, sous une atmosphère inerte, et à sceller ce capot par une colle époxy par exemple. Du fait de l'impossibilité de garantir une atmosphère parfaite à l'intérieur du capot, et du fait de la perméation latérale à travers le scellement, cette technologie n'est pas suffisante. C'est pourquoi on introduit typiquement un matériau « getter » - c'est-à-dire absorbeur d'humidité et/ou de gaz - au sein de ce capot. Le getter peut être, par exemple une zéolithe, un métal, ou un oxyde tel que CaO ou BaO. Par exemple le document US 7,193,364 décrit une encapsulation par capot collé dans lequel le getter forme un cordon entourant le composant à protéger.

Cependant l'utilisation d'un capot rigide en tant que moyen d'encapsulation présente de nombreux inconvénients : industrialisation complexe, limitation des procédés pouvant être mis en œuvre après l'encapsulation (par exemple, dépôt de filtres colorés), incompatibilité fonctionnelle (par exemple pour dispositifs flexibles) ou optique (émission à travers le getter). Par exemple, dans le cadre des écrans OLED avec émission vers le haut (« Top Emission OLED » ou TE-OLED), il n'est pas opportun d'utiliser une encapsulation par capot car l'encapsulation doit être la plus transparente et la moins encombrante possible. De plus, dans le cadre des écrans flexibles, cette encapsulation se doit d'être flexible elle aussi. C'est pourquoi on utilise préférentiellement des barrières d'encapsulation à couches minces. On entend ici par « couches minces » des couches d'épaisseur inférieure ou égale à 10 µm, plus avantageusement à 5 µm et de préférence à 1 µm. Avantageusement, par ailleurs, l'épaisseur d'une couche mince d'encapsulation ne devrait pas être supérieure à 15%, et de préférence à 10%, de la plus petite dimension latérale d'un pixel ou sous-pixel.

Les meilleures encapsulations à couches minces, connues sous le nom de « barrières SHB » (pour « Super-High Barriers », ou « barrières super-hautes » en anglais), constituées par des « dyades », c'est-à-dire des alternances de couches inorganique (typiquement des oxydes) et organiques. Les couches inorganiques peuvent être obtenues par dépôt chimique en phase vapeur (CVD), dépôt physique en phase vapeur (PVD) ou dépôt de couches atomiques (ALD), tandis que les couches organiques peuvent être obtenues par CVD, PVD, impression par jet d'encre ou dépôt à la tournette.

Dans ces structures, l'oxyde joue le rôle de barrière imperméable à l'oxygène et à l'humidité (vapeur d'eau). Le matériau organique est utilisé d'une part pour décorréler les défauts entre deux couches d'oxyde (c'est-à-dire assurer qu'un défaut présent dans une couche inférieure ne se propage pas à une couche supérieure lors du dépôt de cette dernière), et d'autre part pour allonger le chemin de diffusion entre les défauts de deux couches d'oxydes successives. La première couche organique est aussi supposée avoir un effet bénéfique sur la densité de défauts des couches successives, car elle a également une fonction de planarisation. Voir par exemple les documents WO 2000/036665 et WO2011128802.

De manière similaire, le document EP 2 136 423 décrit un composant optoélectronique organique pourvu d'une structure multicouche d'encapsulation comprenant deux couches à base de perfluorohexane (C₆F₆), entre lesquelles sont agencées une couche polymère et une couche à base de SiOx.

De manière générale, plus l'on augmente le nombre de dyades et plus on améliore la qualité protectrice de la barrière. Cependant l'augmentation du nombre de dyades présente des inconvénients : temps de fabrication augmenté, difficulté de réaliser des prises de contact, perte de rendement et filtrage des couleurs dans le cas des OLED, etc.

Par ailleurs, il est impossible d'obtenir des couches barrières inorganiques qui soient réellement exemptes de défauts (particules incluses, piqûres ou « pin-holes » et parfois microfissures). Ainsi, même si les propriétés intrinsèques des barrières sont excellentes, à l'emplacement des défauts les taux de pénétration de l'eau et de l'oxygène sont très nettement accélérés. Les couches organiques permettent de retarder la défaillance du dispositif (chemin de diffusion augmenté et défaut dans la première barrière décorrélé d'un défaut éventuel dans une seconde barrière), cependant l'apparition d'un défaut local de l'OLED est accélérée, et dans certains cas on peut considérer que chaque défaut d'une couche barrière conduit, à terme, à une défaillance totale.

Le document US 6,198,220 décrit une structure d'encapsulation comprenant une couche barrière diélectrique protégée par une couche métallique. Cette dernière est « auto-réparante » au sens qu'elle réagit avec la vapeur d'eau et/ou l'oxygène de telle sorte qu'elle rebouche automatiquement tout défait de type « piqûre ». Cette solution est peu adaptée aux TE-OLED et aux cellules photovoltaïques organiques devant être éclairées par leur face supérieure en raison de l'utilisation de couches métalliques, même si ces dernières sont suffisamment minces pour être partiellement transparentes.

Une autre méthode d'encapsulation à couches minces connue de l'art antérieur consiste à utiliser un getter sous forme d'une couche mince prise en sandwich entre deux couches barrières, afin de capter l'eau ayant diffusé à travers les défauts de la barrière supérieure. Voir par exemple l'article de Byoung Duk Lee et al. « Effect of transparent film desiccant on the lifetime of top-emitting active matrix organic light emitting diodes » Applied Physics Letters 90, 103518 (2007).

Conformément à l'art antérieur on utilise, en tant que getter, soit des métaux tels que Ca Sr ou Ba, soit des oxydes ou sulfures de ces métaux : CaO, CaS, SrO, SrS, BaO, BaS. Toutes ces solutions présentent des inconvénients :
- Les métaux possèdent l'inconvénient majeur d'avoir une influence sur les propriétés optiques de la barrière, ce qui n'est pas acceptable par exemple dans le cadre des microdisplays OLED à émission vers le haut.
- Les oxydes et les sulfures ont l'inconvénient de réagir avec l'eau mais pas avec l'oxygène, et ne permettent donc pas une protection totale du dispositif. De plus les sulfures produisent, en réagissant avec l'eau, du sulfure d'hydrogène qui est un gaz malodorant et très toxique.

Le document US 2007/0273280 décrit une structure d'encapsulation comprenant une alternance de dyades formées chacune par une couche tampon organique et une couche barrière « active » en oxyde ou oxynitrure métallique activé (c'est-à-dire comportant des lacunes d'oxygène), susceptible d'absorber l'eau via une réaction chimique.

L'invention vise à remédier aux inconvénients précités de l'art antérieur. Plus particulièrement, elle vise à procurer une barrière d'encapsulation mince (épaisseur de l'ordre de quelques micromètres, de préférence 1 µm ou moins) présentant un faible taux de défaillance (avantageusement inférieur à celui des barrières SHB de l'art antérieur), transparente (transmittance supérieure ou égale à 90%) et procurant une protection efficace aussi bien à l'encontre de la vapeur d'eau que de l'oxygène. Avantageusement une telle barrière d'encapsulation doit être compatible avec la réalisation d'un dispositif flexible et avec l'ajout de couches fonctionnelles (par exemple : filtres optiques) au-dessus de l'encapsulation, ne pas perturber de manière appréciable le passage de la lumière et/ou être facilement réalisable en environnement industriel avec un rendement élevé.

Conformément à l'invention, ce but est atteint par l'utilisation d'une structure multicouche d'encapsulation comprenant au moins une couche « active » interposée entre des couches barrière inorganiques non métalliques imperméables à l'oxygène et à la vapeur d'eau. Les couches barrières sont réalisées en un oxyde métallique stœchiométrique, l'oxyde de silicium stœchiométrique (SiO₂) ou un oxynitrure de silicium (SiNₓO_{y}) par dépôt de couches atomiques (ALD). Cette technique permet d'obtenir des couches stœchiométriques denses avec seulement quelques défauts de type « piqûre ». Les couches actives sont constituées par (ou, en tout cas, contiennent) au moins un oxyde non-stœchiométrique présentant un défaut d'oxygène, par exemple SiOx avec x inférieur à 2 et typiquement x proche de 1 (par exemple 0,8≤x≤1,2). Ces oxydes capturent l'oxygène ou la vapeur d'eau ayant franchi une couche barrière supérieure, typiquement à cause de la présence de défauts ponctuels ou piqûres, et réagissent avec eux en formant des oxydes stœchiométriques dont la qualité barrière permet de compenser au moins pour partie la défaillance de la couche barrière supérieure. Par ailleurs, la réaction d'un oxyde non-stœchiométrique présentant une lacune en oxygène avec la vapeur d'eau, H₂O, produit du dihydrogène gazeux H₂ ce qui crée une surpression locale. On suppose que cette surpression puisse avoir pour effet de faire diffuser le dihydrogène à travers le ou les défauts de la couche barrière qui recouvre la couche active en entrainant avec soi la vapeur d'eau et l'oxygène ayant pu y pénétrer.

Ainsi, un objet de l'invention est un dispositif encapsulé comprenant :
- un composant optoélectronique organique présentant au moins une surface, dite sensible, devant être protégée de l'oxygène et/ou de la vapeur d'eau ; et
- une structure multicouche d'encapsulation recouvrant au moins ladite surface sensible, comprenant au moins une couche en matériau organique interposée entre une première et une deuxième couche barrière en matériau inorganique non métallique imperméable à l'oxygène et à la vapeur d'eau ; dans lequel:
- lesdites couches barrières sont en un matériau choisi parmi un oxyde métallique stœchiométrique, l'oxyde de silicium stœchiométrique et un oxynitrure de silicium, et réalisées par dépôt de couches atomiques, dans lequel:
- ladite structure multicouche d'encapsulation comprend également au moins une couche, dite active, contenant un oxyde non stœchiométrique présentant une lacune en oxygène, également interposée entre ladite première et ladite deuxième couche barrière, et dans lequel la couche active est réalisée par une technique choisie parmi le dépôt chimique en phase vapeur assisté par plasma, le dépôt chimique en phase vapeur et la pulvérisation cathodique.

Selon différents modes de réalisation d'un tel dispositif :
- Ladite couche active peut être déposée sur ladite couche organique.
- Ladite structure multicouche d'encapsulation peut comprendre une pluralité de paires couche active - couche barrière, réalisées au-dessus de ladite première couche barrière, la structure se terminant par ladite deuxième couche barrière.
- Ladite structure multicouche d'encapsulation peut être sensiblement transparente à la lumière visible.
- Ladite couche active peut contenir un oxyde non stœchiométrique présentant une lacune en oxygène compris entre 40% et 60%.
- Ladite couche active peut contenir au moins un oxyde non stœchiométrique présentant une lacune en oxygène choisi parmi : SiOₓ avec 0<x<2 et avantageusement 0,8≤x≤1,2 ; et MoOₓ avec 0<x<3.
- Ledit composant peut être choisi parmi une diode électroluminescente organique et une cellule photovoltaïque organique, être déposé sur un substrat et comporter une région active, ladite surface sensible étant une surface de ladite région active orientée à l'opposée dudit substrat.

Un autre objet de l'invention est un procédé d'encapsulation d'un composant optoélectronique organique présentant au moins une surface, dite sensible, devant être protégée de l'oxygène et/ou de la vapeur d'eau, caractérisé en ce qu'il comporte les étapes suivantes :
a) réaliser, par dépôt de couches atomiques, sur ou au-dessus de ladite surface sensible, une première couche barrière en un matériau inorganique non métallique imperméable à l'oxygène et à la vapeur d'eau, choisi parmi un oxyde métallique stœchiométrique, l'oxyde de silicium stœchiométrique et un oxynitrure de silicium ;
b) déposer, sur ou au-dessus de ladite première couche barrière, un empilement de couches comprenant au moins une couche en matériau organique et une couche, dite active, contenant un oxyde non stœchiométrique présentant une lacune en oxygène, ladite couche active étant déposée par une technique choisie parmi le dépôt chimique en phase vapeur assisté par plasma, le dépôt chimique en phase vapeur et la pulvérisation cathodique; et
c) réaliser, par dépôt de couches atomiques, sur ou au-dessus dudit empilement de couches, une deuxième couche barrière en matériau inorganique non métallique imperméable à l'oxygène et à la vapeur d'eau, également choisi parmi un oxyde métallique stœchiométrique, l'oxyde de silicium stœchiométrique et un oxynitrure de silicium.

Selon différents modes de réalisation d'un tel procédé :
- Chacune desdites étapes a) et c) peut comprendre au moins une opération de dépôt d'au moins un matériau inorganique non métallique imperméable à l'oxygène et à la vapeur d'eau par une technique choisie parmi : le dépôt chimique en phase vapeur, le dépôt physique en phase vapeur ; le dépôt de couches atomiques et la pulvérisation cathodique.
- Ledit composant peut être choisi parmi une diode électroluminescente organique et une cellule photovoltaïque organique, être déposé sur un substrat et comporter une région active, ladite surface sensible étant une surface de ladite région active orientée à l'opposée dudit substrat, ainsi que des contacts électriques, lesdites étapes a) à c) étant mises en œuvre par des opérations de dépôt sélectif de telle sorte que lesdits contacts électriques ne soient pas recouverts par lesdites couches.

D'autres caractéristiques, détails et avantages de l'invention ressortiront à la lecture de la description faite en référence aux dessins annexés donnés à titre d'exemple et qui représentent, respectivement :
- La figure 1, une vue en coupe d'un dispositif encapsulé selon un premier mode de réalisation de l'invention ; et
- La figure 2, un graphique illustrant les taux de défaillance en fonction du temps d'écrans OLEDs encapsulés conformément à l'invention et à l'art antérieur.

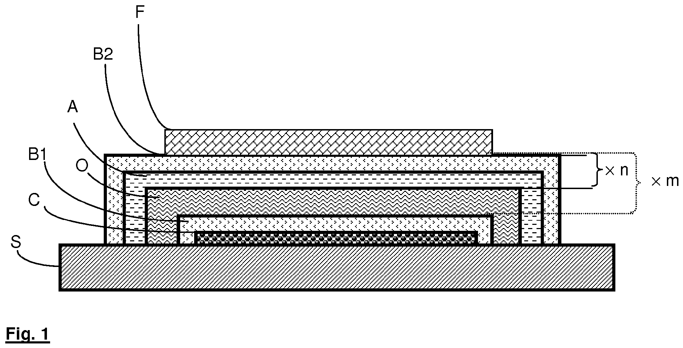

La figure 1 illustre un dispositif selon un mode de réalisation de l'invention, se présentant sous la forme d'un empilement de couches minces - C, B1, O, A, B2 et F - sur un substrat S.

Le substrat S doit être adapté au composant optoélectronique organique C à encapsuler ; il peut s'agir par exemple d'un substrat en silicium, en verre ou en plastique dans le cas d'un dispositif flexible. Le substrat peut inclure, en fonction du composant, des fonctions telles qu'une électronique de contrôle.

Le composant C, déposé sur le substrat S, doit être encapsulé pour être protégé de l'air et de l'eau. Il peut s'agir, notamment, d'une OLED, une micro-batterie ou une cellule photovoltaïque organique (OPV). Dans la suite on considèrera le cas d'une OLED, formée par un empilement de couches minces organiques enfermé entre deux couches conductrices inorganiques formant l'anode et la cathode.

Au-dessus de la face supérieure (opposée au substrat) du composant C se trouve une structure multicouche d'encapsulation comprenant, dans l'ordre :
- Une première couche barrière B1, imperméable à l'oxygène et à la vapeur d'eau. Cette couche - inorganique et non métallique
- peut être constituée par (ou, plus généralement, comprendre) un oxyde métallique stœchiométriques tel que TiO₂, ZrO₂, Al₂O₃, ZnO, SnO₂, l'oxyde de silicium stœchiométriques SiO₂ ou un oxynitrure de silicium SiNₓO_{y}. Dans les applications optiques, ce matériau barrière doit avantageusement être transparent. Comme indiqué plus haut, la couche B1 est déposée par ALD (dépôt de couches atomiques). Son épaisseur dépend des contraintes liées au composant à encapsuler. Par exemple, on peut utiliser 10 - 50 nm d'alumine (Al₂O₃).
- Une couche organique de planarisation O, par exemple en un matériau tel qu'une résine (photosensible ou non), un polymère, ou un parylène, est ensuite déposée au-dessus de la première couche barrière B1. Ce dépôt peut être effectué à la tournette, par PVD, CVD, impression par jet d'encre etc. L'épaisseur de cette couche organique O est limitée par les contraintes liées au composant, elle peut être par exemple de 50-500nm dans le cas d'un micro-écran OLED. La couche organique de planarisation est généralement nécessaire pour compenser le relief du composant à protéger, qui est épousé par la première couche barrière réalisée par ALD - une technique très conformante. La planarisation permet d'assurer une meilleure uniformité de l'épaisseur des couches déposées ultérieurement. De préférence, la couche organique O est déposée au-dessus de la première couche barrière B1 pour ne pas dégrader le composant à protéger.
- Une couche « active » A constituée par (ou, plus généralement, comprenant) un dépôt d'au moins un oxyde non stœchiométrique tel que SiOₓ (0<x<2), MoOₓ, ou tout autre oxyde comportant une lacune en oxygène. Ce dépôt est effectué par toute méthode de dépôt sous vide ou sous atmosphère contrôlée, par exemple sous azote (il est particulièrement important de protéger l'oxyde actif de la vapeur d'eau). Parmi les méthodes de dépôt on utilise le PE-CVD (dépôt chimique en phase vapeur assisté par plasma), le PVD (dépôt physique en phase vapeur) ou la pulvérisation cathodique. L'épaisseur du dépôt est dépendante des contraintes liées au dispositif (absorption optique, encombrement, résistance à la flexion ou autre contraintes...), elle peut par exemple être comprise entre 25nm et 100nm pour des micro-écrans OLED. La stœchiométrie de l'oxyde (valeur de « x », c'est-à-dire teneur en oxygène) peut être contrôlée à l'aide d'une atmosphère contrôlée, par exemple en fixant la pression partielle d'oxygène dans l'atmosphère contrôlée à l'aide d'un contrôleur de flux de masse (MFC de l'anglais « mass flow controller »).
- Une deuxième couche barrière B2, analogue à la couche B1 précitée. La couche active A et, accessoirement, la couche organique O assurent la décorrélation des défauts ponctuels des couches barrière B1 et B2.

Lorsque le dispositif optoélectronique organique doit émettre ou recevoir de la lumière à travers ladite structure d'encapsulation, les matériaux formant les différentes couches doivent être choisis de telle sorte qu'elle soit sensiblement transparente. Cette exigence pose une contrainte sur la teneur en oxygène de l'oxyde non stœchiométrique de la couche active. En effet, dans de nombreux cas (et notamment dans celui du SiOₓ), plus un tel oxyde est pauvre en oxygène, plus il sera absorbant ; réciproquement, plus il sera proche d'une composition stœchiométrique, plus il sera transparent - mais moins il sera apte à réagir avec O₂ et H₂O. Il faudra donc trouver un compromis entre transparence et réactivité de l'oxyde non stœchiométrique, en prenant également en compte son épaisseur. Typiquement, on pourra utiliser des oxydes présentant une lacune en oxygène compris entre 20% ou 25% - mais de préférence au moins 40% - et 60%, avec une épaisseur totale (en prenant en compte la possibilité d'avoir plusieurs couches actives - v. infra) comprise entre 20 et 100nm. La lacune en oxygène D d'un oxyde M_{y}Oₓ est donné par : (s-x)/s · 100%, « s » étant la valeur de l'indice « x » dans la composition stœchiométriques ; par exemple, dans le cas de SiO_{0,8} on a x=0,8 et s=2 ce qui donne D = (2 - 0,8)/2·100 = 60%. Dans le cas de SiO_{1,5} on aura D=(2-1,5)/2·100 = 25%. Un bon compromis entre transparence et réactivité peut être obtenu, par exemple, avec SiOₓ avec 1≤x≤1,5 ou, de préférence 0,8≤x≤1,2.

On remarquera que la structure multicouche d'encapsulation de la figure 1 se différencie d'une encapsulation SHB connue de l'art antérieur essentiellement par l'introduction de la couche active A dans l'espace compris entre la première couche barrière B1 (couche barrière intérieure) et la deuxième couche barrière B2 (couche barrière extérieure).

Dans le cas de la figure 1 la couche organique O est déposée entre la première couche barrière et la couche active A, et la deuxième couche barrière B2 est déposée directement sur cette dernière. D'autres possibilités peuvent cependant être envisagées ; par exemple, la couche active A pourrait être déposée directement sur la première couche barrière B1, la couche organique O étant interposée entre ladite couche active et la deuxième couche barrière ; ou encore, la structure d'encapsulation peut comprendre deux couches organiques intercalées, respectivement entre les couches inorganiques B1 et A d'une part et A et B2 d'autre part ; ces deux variantes sont plus complexes à mettre en œuvre car les procédés doivent être effectués sous atmosphère inerte. Il est également possible de réaliser des empilements plus complexes, comportant plusieurs répétitions des motifs A - B2 (cette possibilité est représentée par le symbole « xn » sur la figure 1), voire O - A - B2 (cette possibilité est représentée par le symbole « xm » sur la figure 1) et/ou A - O - B2. Ce qui est important est que la structure multicouche comporte un empilement comprenant au moins une couche active en oxyde non stœchiométrique avec une lacune en oxygène et une couche organique de planarisation, ledit empilement étant enfermé entre deux couches barrières inorganiques et non métalliques réalisées par ALD.

Une couche ou structure multicouches F, dite « fonctionnelle », peut être déposée au-dessus de la couche barrière supérieure afin de réaliser toute fonction utile au dispositif ; la structure F peut comprendre, par exemple, une couche de protection contre les rayures et/ou un filtre coloré et/ou un traitement antireflet etc. Elle est optionnelle.

Sur la figure 1, la structure multicouche d'encapsulation semble recouvrir complètement le composant C. En pratique, toutefois, certaines parties non sensibles du composant pourront être dégagées, en particulier des contacts électriques permettant d'alimenter ledit composant. Ce dégagement peut être obtenu en déposant les différentes couches de manière sélective, par exemple, à l'aide d'un pochoir ou masque, ou par gravure après dépôt.

Les performances d'une encapsulation sont typiquement définies par le taux de transmission de la vapeur d'eau (WVTR de l'anglais « Water Vapor Transmission Rate ») mesuré en g/m²/h. Cet indicateur est typiquement mesuré en étuve humide avec une atmosphère qui permet l'accélération de la défaillance de la structure barrière. On définit de plus un indicateur nommé « lag-time » (temps de retard) qui mesure le temps nécessaire à l'apparition du premier défaut. Ces deux indicateurs sont typiquement établit par la méthode dite du « Calcium-test », qui consiste à mesurer l'oxydation d'un plot de Calcium déposé sous la couche barrière. Cette mesure est généralement effectuée par l'intermédiaire de la résistivité électrique, ou de la transparence optique.

Cependant un autre indicateur plus représentatif dans le cadre industriel est le taux de défaillance de dispositifs initialement sans défauts, après un temps indiqué en étuve humide. Cet indicateur est une mesure indirecte des deux indicateurs discutés ci-dessus (WVTR et lag-time). Il possède l'avantage de pouvoir être déterminé sur une structure complète comprenant les couches OLED ainsi que le substrat.

Une structure d'encapsulation selon l'invention a été testée en mesurant le taux de défaillance d'écrans OLED présentant les caractéristiques suivantes :
- substrat en silicium comprenant une couche de métallisation et une anode pixellisée avec une taille de pixels de l'ordre de 5µm ;
- les composants sensibles à encapsuler sont des OLED composées d'empilements : anode métallique pixellisée / empilement OLED de couches organiques/ cathode métallique, « capping layer » en SiOₓ (destiné à favoriser l'extraction de lumière) ;

- l'encapsulation est du type illustré sur la figure 1, mais sans couche de fonctionnalisation F. Plus particulièrement :
- la première couche barrière B1 consiste en 20-30 nm d'Al₂O₃ et est déposée par ALD ;
- la couche organique de planarisation, O, consiste en 300nm d'une résine photosensible déposée à la tournette. La photosensibilité de la résine sera exploitée ultérieurement, en l'insolant et en la développant pour dégager les contacts électriques et la zone de découpe.

La couche active d'oxyde non-stœchiométrique A est réalisée en SiOₓ avec x proche de 1 (valeur exacte de « x » non connue, mais comprise entre 0,8 et 1,2) déposé par PVD sous vide. Elle n'est jamais mise en contact avec l'atmosphère. Dans un but de comparaison, on considère deux épaisseurs différentes de cette couche : 25 nm et 100 nm.

La deuxième couche barrière B2 consiste, elle aussi, en 20-30 nm d'Al₂O₃ et est déposée par ALD.

A titre de référence, ont également été considérés des écrans dans lesquels la couche d'oxyde non stœchiométrique A n'a pas été déposée. Il s'agit donc d'une encapsulation de type « SHB » conventionnelle.

Des essais ont été réalisés sur des plaques comprenant chacune 288 écrans potentiellement utilisables. Ces plaques ont été testées initialement de manière automatisée en prenant une photographie de chaque écran. Ces photographies ont été triées à l'aide d'un logiciel afin de déterminer l'échantillon de chaque plaque, c'est-à-dire les écrans ne présentant aucun défaut initialement.

Les plaques ont ensuite été soumises à une atmosphère contrôlée en étuve humide (60°C/90% d'humidité) par périodes de 168h, toutes les plaques étant soumises à l'atmosphère au sein de la même étuve.

A chaque période de 168h d'étuvage, les plaques ont été testées à nouveau en prenant une photographie de chaque écran puis en triant ces photographies pour détecter les défauts. On a cherché particulièrement à repérer les défauts de type points noirs (zones non émissives) qui sont caractéristiques de défauts provoqués parla pénétration d'eau à travers l'encapsulation.

Les résultats du tri ont été comparés afin de quantifier le nombre d'écrans ayant développé un défaut au cours du vieillissement, c'est-à-dire les écrans pour lesquelles l'encapsulation a présenté une défaillance.

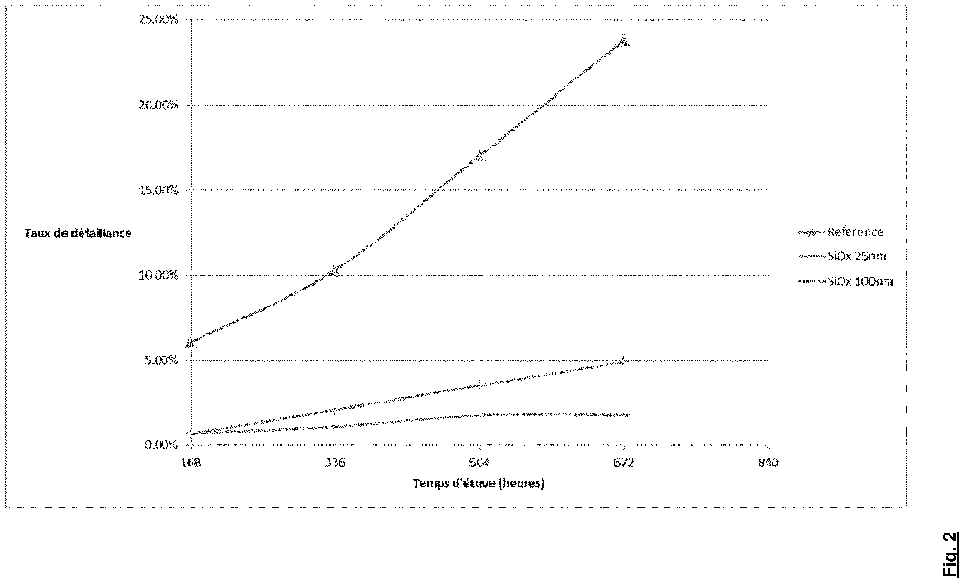

Ces résultats sont présentés sur la figure 2. On peut remarquer que l'ajout d'une couche très mince (25 nm) d'oxyde non-stœchiométrique avec une lacune en oxygène améliore très sensiblement la protection assurée par un empilement SHB, réduisant le taux de défaillance d'environ un facteur 5. L'augmentation à 100 nm de l'épaisseur de cette couche fournit une amélioration supplémentaire, significative surtout pour des temps d'étuve longs (supérieurs à 500 h).

## Revendications

1. Dispositif encapsulé comprenant :
- un composant optoélectronique organique (C) présentant au moins une surface, dite sensible, devant être protégée de l'oxygène et/ou de la vapeur d'eau ; et
- une structure multicouche d'encapsulation recouvrant au moins ladite surface sensible, comprenant au moins une couche en matériau organique (O) interposée entre une première (B1) et une deuxième (B2) couche barrière en matériau inorganique non métallique imperméable à l'oxygène et à la vapeur d'eau ; dans lequel
- lesdites couches barrières sont en un matériau choisi parmi un oxyde métallique stœchiométrique, l'oxyde de silicium stœchiométrique et un oxynitrure de silicium, et réalisées par dépôt de couches atomiques,
- ladite structure multicouche d'encapsulation comprend également au moins une couche (A), dite active, contenant un oxyde, également interposée entre ladite première et ladite deuxième couche barrière,
**caractérisé en ce que**
l'oxyde de la couche active est un oxyde non stoechiométrique présentant une lacune en oxygène, et **en ce que**
la couche active est réalisée par une technique choisie parmi le dépôt chimique en phase vapeur assisté par plasma, le dépôt chimique en phase vapeur et la pulvérisation cathodique.

2. Dispositif selon la revendication 1 dans lequel ladite couche active est déposée sur ladite couche organique.

3. Dispositif selon la revendication 1 dans lequel ladite structure multicouche d'encapsulation comprend une pluralité de paires couche active - couche barrière réalisées au-dessus de ladite première couche barrière, la structure se terminant par ladite deuxième couche barrière.

4. Dispositif selon l'une des revendications précédentes dans lequel ladite structure multicouche d'encapsulation est sensiblement transparente à la lumière visible.

5. Dispositif selon l'une des revendications précédentes dans lequel ladite couche active contient un oxyde non stœchiométrique présentant une lacune en oxygène compris entre 40% et 60%.

6. Dispositif selon l'une des revendications précédentes dans lequel ladite couche active contient au moins un oxyde non stœchiométrique présentant une lacune en oxygène choisi parmi :
- SiOₓ avec 0<x<2 et avantageusement 0,8≤x≤1,2 ; et
- MoOₓ avec 0<x<3.

7. Dispositif selon l'une des revendications précédentes dans lequel ledit composant (C) est choisi parmi une diode électroluminescente organique et une cellule photovoltaïque organique, est déposé sur un substrat (S) et comporte une région active, ladite surface sensible étant une surface de ladite région active orientée à l'opposée dudit substrat.

8. Procédé d'encapsulation d'un composant optoélectronique organique (C) présentant au moins une surface, dite sensible, devant être protégée de l'oxygène et/ou de la vapeur d'eau, **caractérisé en ce qu'**il comporte les étapes suivantes :
a) réaliser, par dépôt de couches atomiques, sur ou au-dessus de ladite surface sensible, une première couche barrière (B1) en un matériau inorganique non métallique imperméable à l'oxygène et à la vapeur d'eau, choisi parmi un oxyde métallique stœchiométrique, l'oxyde de silicium stœchiométrique et un oxynitrure de silicium ;
b) déposer, sur ou au-dessus de ladite première couche barrière, un empilement de couches comprenant au moins une couche en matériau organique (O) et une couche (A), dite active, contenant un oxyde non stœchiométrique présentant une lacune en oxygène, ladite couche active étant déposée par une technique choisie parmi le dépôt chimique en phase vapeur assisté par plasma, le dépôt chimique en phase vapeur et la pulvérisation cathodique ; et
c) réaliser, par dépôt de couches atomiques, sur ou au-dessus dudit empilement de couches, une deuxième couche barrière (B2) en matériau inorganique non métallique imperméable à l'oxygène et à la vapeur d'eau, également choisi parmi un oxyde métallique stœchiométrique, l'oxyde de silicium stœchiométrique et un oxynitrure de silicium.

9. Procédé selon la revendication dans lequel ladite étape b) comprend également une opération de dépôt d'au moins une couche en matériau organique par une technique choisie parmi : le dépôt à la tournette, l'impression par jet d'encre, le dépôt chimique en phase vapeur, le dépôt physique en phase vapeur.

10. Procédé selon l'une des revendications 8 ou 9 dans lequel ledit composant (C) est choisi parmi une diode électroluminescente organique et une cellule photovoltaïque organique, est déposé sur un substrat (S) et comporte une région active, ladite surface sensible étant une surface de ladite région active orientée à l'opposée dudit substrat, ainsi que des contacts électriques, lesdites étapes a) à c) étant mises en œuvre par des opérations de dépôt sélectif de telle sorte que lesdits contacts électriques ne soient pas recouverts par lesdites couches.

## Patentansprüche

1. Verkapselte Vorrichtung, Folgendes beinhaltend:
- eine organische optoelektronische Komponente (C), welche mindestens eine empfindlich genannte Oberfläche aufweist, welche vor Sauerstoff und/oder Wasserdampf geschützt werden muss; und
- eine mehrschichtige Verkapselungsstruktur, welche mindestens die empfindliche Oberfläche bedeckt, beinhaltend mindestens eine Schicht aus organischem Material (O), welche zwischen einer ersten (B1) und einer zweiten (B2) Barriereschicht zwischengeschaltet ist, welche aus anorganischem, nicht metallischem, sauerstoff- und wasserdampfundurchlässigem Material bestehen;
wobei
- die Barriereschichten aus einem Material gewählt aus einem stöchiometrischen Metalloxid, dem stöchiometrischen Siliziumoxid und einem Siliziumoxinitrid bestehen, und anhand von Atomanlagen-Ablagerung hergestellt werden,
- die mehrschichtige Verkapselungsstruktur ebenfalls mindestens eine aktiv genannte Schicht (A) beinhaltet, welche ein Oxid enthält, welche ebenfalls zwischen der ersten und der zweiten Barriereschicht zwischengeschaltet ist,
**dadurch gekennzeichnet, dass**
das Oxid der aktiven Schicht ein nicht stöchiometrisches Oxid ist, welches eine Sauerstofflücke aufweist, und dadurch, dass
die aktive Schicht anhand einer Technik gewählt aus plasmagestützter chemischer Ablagerung in der Dampfphase, chemischer Ablagerung in der Dampfphase und kathodischer Zerstäubung hergestellt wird.

2. Vorrichtung nach Anspruch 1, bei welcher die aktive Schicht auf der organischen Schicht abgelagert wird.

3. Vorrichtung nach Anspruch 1, bei welcher die mehrschichtige Verkapselungsstruktur eine Vielzahl von Paaren aus aktiver Schicht und Barriereschicht beinhaltet, welche oberhalb der ersten Barriereschicht hergestellt werden, wobei die Struktur mit der zweiten Barriereschicht endet.

4. Vorrichtung nach einem der vorhergehenden Ansprüche, bei welcher die mehrschichtige Verkapselungsstruktur im Wesentlichen für sichtbares Licht transparent ist.

5. Vorrichtung nach einem der vorhergehenden Ansprüche, bei welcher die aktive Schicht ein nicht stöchiometrisches Oxid enthält, welches eine Sauerstofflücke zwischen 40 % und 60 % aufweist.

6. Vorrichtung nach einem der vorhergehenden Ansprüche, bei welcher die aktive Schicht mindestens ein nicht stöchiometrisches Oxid enthält, welches eine Sauerstofflücke aufweist, gewählt aus:
- SiOₓ, wobei 0<x<2 und vorteilhafterweise 0,8≤x≤1,2; und
- MoOₓ, wobei 0<x<3.

7. Vorrichtung nach einem der vorhergehenden Ansprüche, bei welchem die Komponente (C) aus einer organischen lichtemittierenden Diode und einer organischen Fotovoltaikzelle gewählt ist, auf einem Substrat (S) abgelagert ist, und einen aktiven Bereich beinhaltet, wobei die empfindliche Oberfläche eine Oberfläche des aktiven Bereichs ist, welche dem Substrat abgewandt ausgerichtet ist.

8. Verkapselungsverfahren einer organischen optoelektronischen Komponente (C), welche mindestens eine empfindlich genannte Oberfläche aufweist, welche vor Sauerstoff und/oder Wasserdampf geschützt werden muss, **dadurch gekennzeichnet, dass** es folgende Schritte beinhaltet:
a) Herstellen, durch Atomlagen-Ablagerung, auf oder über der empfindlichen Oberfläche, einer ersten Barriereschicht (B1) aus einem anorganischen, nicht metallischen, sauerstoff- und wasserdampfundurchlässigen Material, gewählt aus einem stöchiometrischen Metalloxid, dem stöchiometrischen Siliziumoxid und einem Siliziumoxinitrid;
b) Ablagern, auf oder über der ersten Barriereschicht, eines Stapels von Schichten, beinhaltend mindestens eine Schicht aus organischem Material (O) und eine aktiv genannte Schicht (A), enthaltend ein nicht stöchiometrisches Oxid, welches eine Sauerstofflücke aufweist, wobei die aktive Schicht anhand einer Technik gewählt aus plasmagestützter chemischer Ablagerung in der Dampfphase, chemischer Ablagerung in der Dampfphase und kathodischer Zerstäubung abgelagert wird; und
c) Herstellen, durch Atomlagen-Ablagerung, auf oder über dem Stapel von Schichten, einer zweiten Barriereschicht (B2) aus anorganischem, nicht metallischem, sauerstoff- und wasserdampfundurchlässigem Material, ebenfalls gewählt aus einem stöchiometrischen Metalloxid, dem stöchiometrischen Siliziumoxid und einem Siliziumoxinitrid.

9. Verfahren nach Anspruch 8, bei welchem der Schritt b) ebenfalls einen Vorgang zur Ablagerung mindestens einer Schicht aus organischem Material anhand einer Technik gewählt aus Schleuderbeschichten, Tintenstrahldruck, chemischer Ablagerung in der Dampfphase, physikalischer Ablagerung in der Dampfphase beinhaltet.

10. Verfahren nach einem der Ansprüche 8 oder 9, bei welchem die Komponente (C) aus einer organischen lichtemittierenden Diode und einer organischen Photovoltaikzelle gewählt ist, auf einem Substrat (S) abgelagert ist, und einen aktiven Bereich beinhaltet, wobei die empfindliche Oberfläche eine Oberfläche des aktiven Bereichs ist, welche dem Substrat abgewandt ausgerichtet ist, sowie elektrische Kontakte beinhaltet, wobei die Schritte a) bis c) anhand von selektiven Ablagerungsvorgängen in einer Weise durchgeführt werden, dass die elektrischen Kontakte nicht durch die Schichten bedeckt werden.

## Claims

1. An encapsulated device comprising:
- an organic optoelectronic component (C) exhibiting at least one surface, called sensitive surface, which has to be protected from oxygen and/or from water vapor; and
- a multilayer encapsulation structure covering at least said sensitive surface, comprising at least one layer made of organic material (O) interposed between a first (B1) and a second (B2) barrier layer made of nonmetallic inorganic material impermeable to oxygen and to water vapor;
wherein
- said barrier layers are made of a material chosen from a stoichiometric metal oxide, stoichiometric silicon oxide and a silicon oxynitride and produced by atomic layer deposition,
- said multilayer encapsulation structure also comprises at least one layer, called active layer (A), containing an oxide, also interposed between said first and said second barrier layer
**characterized in that**
the oxide from the active layer is a nonstoichiometric oxide exhibiting an oxygen deficiency, and **in that**
the active layer is made by a technique chosen from: plasma assisted chemical vapor deposition, chemical vapor deposition and cathode sputtering.

2. The device as claimed in claim 1, in which said active layer is deposited on said organic layer.

3. The device as claimed in claim 1, in which said multilayer encapsulation structure comprises a plurality of active layer-barrier layer pairs produced above said first barrier layer, the structure terminating in said second barrier layer.

4. The device as claimed in one of the preceding claims, in which said multilayer encapsulation structure is substantially transparent to visible light.

5. The device as claimed in one of the preceding claims, in which said active layer contains a nonstoichiometric oxide exhibiting an oxygen deficiency of between 40% and 60%.

6. The device as claimed in one of the preceding claims, in which said active layer contains at least one nonstoichiometric oxide exhibiting an oxygen deficiency chosen from:
- SiOₓ with 0<x<2 and advantageously 0.8≤x≤1.2; and
- MoOₓ with 0<x<3.

7. The device as claimed in one of the preceding claims, in which said component (C) is chosen from an organic light-emitting diode and an organic photovoltaic cell, is deposited on a substrate (S) and comprises an active region, said sensitive surface being a surface of said active region facing away from said substrate.

8. A process for the encapsulation of an organic optoelectronic component (C) exhibiting at least one surface, called sensitive surface, which has to be protected from oxygen and/or from water vapor, **characterized in that** it comprises the following stages:
a) producing, by atomic layer deposition, on or above said sensitive surface, a first barrier layer (B1) made of a nonmetallic inorganic material impermeable to oxygen and to water vapor, chosen from a stoichiometric metal oxide, stoichiometric silicon oxide and a silicon oxynitride;
b) depositing, on or above said first barrier layer, a stack of layers comprising at least one layer made of organic material (O) and a layer, called active layer (A), containing a nonstoichiometric oxide exhibiting an oxygen deficiency, said active layer being deposited by a technique chosen from: plasma assisted chemical vapor deposition, chemical vapor deposition and cathode sputtering; and
c) producing, by atomic layer deposition, on or above said stack of layers, a second barrier layer (B2) made of nonmetallic inorganic material impermeable to oxygen and to water vapor, also chosen from a stoichiometric metal oxide, stoichiometric silicon oxide and a silicon oxynitride.

9. The process as claimed in claim 8, in which said step b) also comprises an operation for the deposition of at least one layer made of organic material by a technique chosen from: spin coating, inkjet printing, chemical vapor deposition, physical vapor deposition.

10. The process as claimed in either of claims 8 or 9, in which said component (C) is chosen from an organic light-emitting diode and an organic photovoltaic cell, is deposited on a substrate (S) and comprises an active region, said sensitive surface being a surface of said active region facing away from said substrate, and also electrical contacts, said steps a) to c) being carried out by selective deposition operations so that said electrical contacts are not covered by said layers.
